Europäisches Patentamt

European Patent Office

Office européen des brevets

(11) Publication number: **0 261 245 B1**

(19)

# EUROPEAN PATENT SPECIFICATION

(45) Date of publication of patent specification: **30.09.92**

(51) Int. Cl.⁵: **H01B 13/00**, C08J 7/00, C23C 14/08, C23C 14/32, C23C 14/56

(21) Application number: **87901677.2**

(22) Date of filing: **11.03.87**

(86) International application number:
**PCT/JP87/00152**

(87) International publication number:
**WO 87/05742 (24.09.87 87/21)**

(54) **PROCESS FOR PRODUCING TRANSPARENT CONDUCTIVE FILM.**

(30) Priority: **12.03.86 JP 54162/86**

(43) Date of publication of application:
**30.03.88 Bulletin 88/13**

(45) Publication of the grant of the patent:
**30.09.92 Bulletin 92/40**

(84) Designated Contracting States:
**DE FR GB IT NL**

(56) References cited:
**EP-A- 0 112 132      EP-A- 0 161 088**
**FR-A- 2 376 485      JP-A-56 136 410**
**US-A- 3 562 141      US-A- 4 526 132**

**Shinku, Vol. 27, No. 2, 20 February 1984 (20.02.84) (Tokyo) Uramoto Joshin "Ion Plating notameno Hoden Plasma Ryu no Magekata" PP64-71, Especially, see Fig. 9**

(73) Proprietor: **TOBI CO., LTD.**
**16-14, Hanaten Nishi 2-chome, Jyoto-ku**
**Osaka-shi, Osaka 536(JP)**

Proprietor: **MURAYAMA, Yoichi**
**304, Domuso Mejiro, 17-44 Shimoochiai**
**3-chome**
**Shinjuku-ku, Tokyo 161(JP)**

(72) Inventor: **NOMACHI, Tetsuya**
**6-21, Tanabecho Osumigaoka 2-chome**
**Tuzuki-gun**
**Kyoto 610-03(JP)**
Inventor: **MURAYAMA,Yoichi**
**304,Domuso Mejiro,17-44 Shimoochiai**
**3-chome**
**Shinjuku-ku, Tokyo 161(JP)**

(74) Representative: **Davies, Christopher Robert et al**
**Frank B. Dehn & Co. Imperial House 15-19 Kingsway**
**London WC2B 6UZ(GB)**

EP 0 261 245 B1

JP, A, 54-6878 (Fuji Photo Film Co., Ltd.) 19 January 1979 (19.01.79) page 5, upper left column, lines 3 to 5, page 5 upper right column, lines 10 to 14, page 5, lower right column, lines 5 to 10 (Family: none)

## Description

This invention relates to a process for manufacturing transparent, conductive film. In more detail, the invention relates to a process for manufacturing high-quality transparent, conductive film at high speed using the ion-plating method.

Conductive film consisting of plastic, etc. is expected to be used in various fields such as for antistatic materials, electromagnetic wave shields, touch panels and display units. The process for manufacturing conductive film by depositing thin film of a conductive material such as metal and metal oxide on the surface of a film made from plastics, as well as by providing organic polymer itself with conductivity are generally well-known.

The process providing organic polymer with conductivity is, however, now in the fundamentally investigative stage. There are many unsolved problems remaining in the process of depositing thin film of a conductive material, though commercialization is expected.

Methods have been proposed for depositing thin film such that the thin film is deposited on the surface of plastic film moving from the delivery roll to the wind-up roll by methods such as metallizing sputtering and hollow cathode ion-plating. This method has, however, serious problems such as poor productivity due to low depositing reactivity of thin film, inevitable adhesion of dirt to the manufacturing apparatus including the cathode, low thermal stability and unavoidable heat build-up in the plastic substrate. Therefore, thin conductive film with good conductivity, high adhesiveness to the substrate, good durability and uniform quality has not been effectively manufactured.

Such a film with high transparency, which is indispensable to the growth of practical use as functional film has not yet been manufactured.

US 4526132 discloses apparatus for ion-plating a fast moving film with a thin film, whereby a discharger ionizes all the gas in the vacuum chamber.

This invention aims to provide an effective process free from those problems for manufacturing high-quality, transparent, conductive film. In more detail, the invention provides a process for manufacturing transparent, conductive film comprising moving a plastic film at high velocity and depositing a transparent, conductive thin film on the surface of the moving film by ion-plating using a pressure gradient plasma gun.

Thus the invention entails a process for manufacturing transparent, conductive film by high-speed ion-plating method using pressure-gradient discharge and deposition of a thin film of conductive material such as indium oxide, tin oxide, ITO etc. on the surface of film moving at high velocity from the delivery roll to the wind-up roll.

The pressure-gradient discharge is made such that the intermediate electrode is located between the anode and the cathode, maintaining pressure at the anode and cathode regions at approximately 133Pa (1 Torr) and $133 \times 10^{-3}$Pa ($10^{-3}$ Torr) respectively. Use of this discharging method for ion-plating has already been proposed(Vacuum, Vol. 27, No. 2, p.64, 1984).

The ion-plating method is used for dry-coating on the surface of material to be treated so that plasma flow is emitted horizontally from the plasma source and turned perpendicularly right above the hearth, which is placed turning upward so that the plasma converges to ionize the raw material for thin film.

This method has many advantages - non-adhesion of dirt on the plasma gun, high reaction rate, uniformity and high adhesivity of the thin film.

Ion-plating by pressure-gradient discharge has never been adequately investigated in terms of applied technology and developing practical apparatus. Especially, the application of ion-plating to manufacturing transparent, conductive film at high speed and the selection of operational conditions and process as well as dry-coating of moving articles of film material have not yet been developed. This invention has realized the above-mentioned items for the first time.

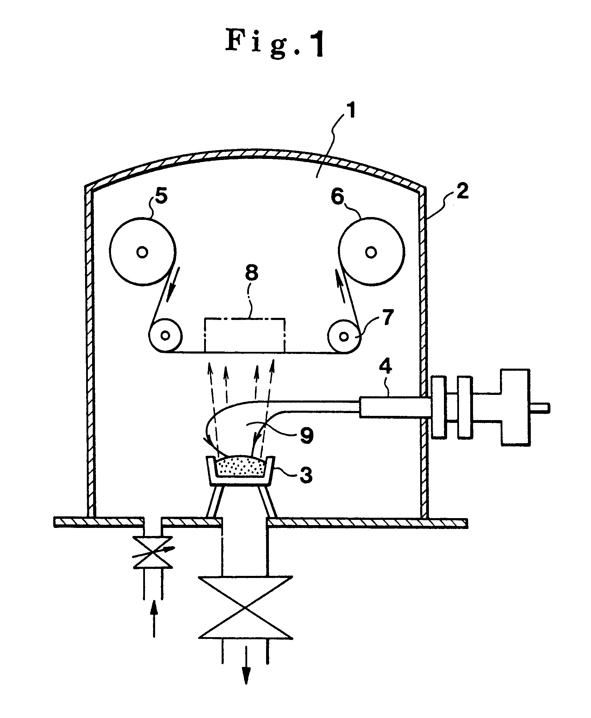

Fig. 1 shows an example of the apparatus for manufacturing transparent, conductive film according to a preferred embodiment of the invention.

A preferred embodiment of the invention will now be described in more detail, by way of example only, with the attached figure, Fig. 1, as follows:

(1) is a vacuum chamber which is kept air-tight with a bell-jar (2). The vacuum chamber is evacuated by a vacuum pump. The bell-jar (2) has an inlet for the reaction gas and a vacuum port. The hearth (3) for the raw material for transparent, conductive thin film, pressure-gradient plasma gun (4), film delivery roll (5) and the wind-up roll (6) of transparent, conductive film are mounted in the bell-jar (2). If necessary, the guide-rolls (7) and cooling device (8) may be installed.

Although the cross-section of a box-type bell-jar is shown in Fig. 1, the shape and construction are not necessarily limited to this type.

A water-cooling or air-cooling device is installed to cool the driving gear of the rolls. A forced heating

EP 0 261 245 B1

device such as an electric resistance heater, electron-beam heater, high-frequency heater etc. can be used as the evaporating heat source, taking the evaporated material and productivity into consideration.

The bell-jar may be furnished with a gate on the side wall to freely take in and remove the part containing the rolls, the part containing rolls with the cooling device or the part of hearth through the gate.

Naturally, the method based on the invention is not limited to the apparatus mentioned above.

For instance, the part containing rolls is not necessarily installed inside the bell-jar. A film moving mechanism may be installed in the pretreatment sections such as the plasma bombarding treatment or the post-treatment section adjoining the thin film depositing section to pass the film through a slit formed on the side wall of the bell-jar. A radio frequency exciting plasma device and a device applying negative voltage to the surface of the film can be also installed in the space above the hearth.

The process conditions for manufacturing transparent, conductive film using high-speed film ion-plating apparatus shown in Fig. 1 are as follows:

Any heat-resistant film made from polyester such as polyethylene terephthalate (PET), polysulfone, polyimide etc. can be used for the process of the invention by winding the film at high velocity as fast as 8 to 30m/min. The thickness of the substrate can be chosen in a wide range from 5 to 250$\mu$m, depending on uses of the transparent, conductive film. It is preferable that the width of film be approximately 1.5m or less.

Conductive oxides such as indium oxide, tin oxide, ITO etc. and other suitable substances can be used as the raw material for transparent, conductive thin film.

The reaction pressure is most preferable to be $9.3 \times 10^{-2}$Pa to $12 \times 10^{-2}$Pa (7 to $9 \times 10^{-4}$ Torr) within the range from $1.3 \times 10^{-3}$Pa to 13Pa ($1 \times 10^{-5}$ to $10^{-1}$ Torr). Oxygen is introduced in the bell-jar to a pressure of $7 \times 10^{-2}$Pa to $9 \times 10^{-2}$Pa ($5 \times 10^{-4}$ to $7 \times 10^{-4}$ Torr) to produce the thin oxide film. The temperature is 150°C or less and the discharge voltage is 50 to 100V. The current is varied according to the evaporated material.

According to this invention, it is now possible to manufacture highly conductive film with excellent transparency and extremely reduced light transmission at a velocity as high as 8 to 30m/min, a result which is not possible with conventional technologies.

This invention will now be further illustrated by an example.

Example

Transparent, conductive film was manufactured using PET film 250mm wide. ITO containing 5% of SnO$_2$ was used as the evaporated material. The distance between the hearth on which this raw material was put and the film was 40cm. No cooling device was used.

The moving or winding velocity was set at 18m/min.

The reaction was operated under the following conditions:

| (1) | Discharge | 250 A/70V |
| | Pressure of argon | $10 \times 10^{-2}$Pa ($7.5 \times 10^{-4}$ Torr) |
| | Pressure of oxygen | $12 \times 10^{-2}$Pa ($9 \times 10^{-4}$ Torr) |
| (2) | Discharge | 240A/65V |
| | Pressure of argon | $11.3 \times 10^{-2}$Pa ($8.5 \times 10^{-4}$ Torr) |
| | Pressure of oxygen | $13.3 \times 10^{-2}$Pa ($1.0 \times 10^{-3}$ Torr) |

In Experiment (1), a thin, transparent film with a thickness of 130 nm (1300 Å) and 83% parallel light transmission of 550nm (87% in the PET blank test) was obtained. The resistance of the film was 140 to 146 $\Omega/\square$.

Also, in Experiment (2), film with a similar light transmission was obtained. The resistance of the film was 180 to 210 $\Omega/\square$.

It is now possible to realize the manufacture of high-quality, transparent, conductive film at high velocity by this invention. The transparent, conductive film is suitable as antistatic material and as material for electronic and electric apparatus such as electromagnetic wave shields, touch panels and indication elements.

**Claims**

1. A process for manufacturing a transparent, conductive film characterized by:
   moving a plastic film at high velocity, and

4

depositing a transparent, conductive, thin film on the surface of the moving film by ion-plating using a pressure-gradient plasma gun (4).

2. The process as claimed in Claim 1, wherein the plastic film is moved at a velocity between 8 and 30m/min.

3. Process as claimed in Claim 1 or 2 further characterized by moving the film between film delivery (5) and wind up (6) rolls;

evaporating raw material for forming a thin film from a hearth (3) located in a vacuum chamber (1);

ionizing the evaporated material by converging the plasma flow (9) emitted from said pressure-gradient plasma gun (4) on the evaporated material, and

depositing the thin film of the ionized particles on the surface of the film moving at high velocity from said delivery roll (5) to said wind-up roll (6).

**Patentansprüche**

1. Verfahren zur Herstellung eines transparenten, leitfähigen Films **gekennzeichnet durch**:

Bewegen eines Kunststoffilms mit hoher Geschwindigkeit, und

Aufbringen eines transparenten, leitfähigen, dünnen Films auf die Oberfläche des sich bewegenden Films durch Ionplating unter Verwendung einer Druckgradienten-Plasmakanone (4).

2. Verfahren nach Anspruch 1, bei welchem der Kunststoffilm mit einer Geschwindigkeit zwischen 8 und 30 m/min bewegt wird.

3. Verfahren nach Anspruch 1 oder 2 darüber hinaus gekennzeichnet durch

Bewegen des Films zwischen einer Filmlieferrolle (5) und einer Aufwickelrolle (6);

Verdampfen von Rohmaterial zur Bildung eines dünnen Films von einer Heizstelle (3), die in einer Vakuumkammer (1) angeordnet ist;

Ionisieren des verdampften Materials durch Zusammenführen des von der Druckgradienten-Plasmakanone (4) emittierten Plasmaflusses (9) auf das verdampfte Material, und

Aufbringen des dünnen Films der ionisierten Partikel auf die Oberfläche des Films, der sich mit hoher Geschwindigkeit von der Lieferrolle (5) zur Aufwickelrolle (6) bewegt.

**Revendications**

1. Procédé de fabrication d'un film conducteur transparent, caractérisé en ce que

- on fait avancer, à grande vitesse, un film en matière plastique et
- on dépose un film conducteur transparent mince à la surface du film an mouvement, par ionoplastie, en utilisant un pistolet à plasma (4) à gradient de pression.

2. Procédé tel que revendiqué dans la revendication 1, caractérisé en ce qu'on fait avancer le film en matière plastique à une vitesse comprise entre 8 et 30 m/min.

3. Procédé tel que revendiqué dans la revendication 1 ou 2, caractérisé en ce que

- on fait avancer le film entre un cylindre d'alimentation (5) et un cylindre d'enroulement (6),
- on fait évaporer, sur un foyer (3) situé dans une chambre à vide (1), le matériau brut, afin de former un film mince,
- on ionise le matériau évaporé en faisant converger le courant de plasma (9), émis par ledit pistolet à plasma (4) à gradient de pression, sur le matériau évaporé, et
- on dépose le film mince de particules ionisées à la surface du film, qui avance rapidement depuis le cylindre d'alimentation (5) jusqu'audit cylindre d'enroulement (6).

# Fig.1